# EUROPÄISCHE PATENTSCHRIFT

(11) **EP 1 449 220 B1**
(45) Veröffentlichungstag und Bekanntmachung des Hinweises auf die Patenterteilung: **30.03.2005**
(21) Anmeldenummer: 02787395.9
(22) Anmeldetag: 25.11.2002
(51) Int. Cl.: G11C 11/16

(54) **MAGNETORESISTIVE SPEICHERZELLE MIT DYNAMISCHER REFERENZSCHICHT**
MAGNETORESISTIVE MEMORY CELL COMPRISING A DYNAMIC REFERENCE LAYER
CELLULE MEMOIRE MAGNETORESISTIVE A COUCHE DE REFERENCE DYNAMIQUE

(30) Priorität: 30.11.2001 DE 10158795
(43) Veröffentlichungstag der Anmeldung: 25.08.2004
(73) Patentinhaber: Infineon Technologies AG, 81669 München (DE)
(72) Erfinder: BANGERT, Joachim, 91052 Erlangen (DE)
(74) Vertreter: Kottmann, Heinz Dieter, Dipl.-Ing.
(86) Internationale Anmeldenummer: PCT/DE2002/004323
(87) Internationale Veröffentlichungsnummer: WO 2003/049120

(56) Entgegenhaltungen:
- EP-A- 0 875 901
- EP-A- 1 296 331

## Beschreibung

Die vorliegende Erfindung betrifft eine Anordnung zur Erhöhung einer relativen Widerstandsdifferenz einer magnetoresistiven Speicherzelle mit jeweils einer Speicherschicht und einer Referenzschicht beidseits einer Tunnelbarriere zwischen einem ersten Magnetisierungszustand, in dem eine Magnetisierung der Speicherschicht einer Referenzmagnetisierung der Referenzschicht gleichgerichtet ist und einem zweiten Zustand, in dem die Magnetisierung der Referenzmagnetisierung entgegengerichtet ist, in einer Halbleitereinrichtung.

Eine magnetoresistive Speicherzelle besteht üblicherweise aus zwei ferromagnetischen Systemen mit einer dazwischenliegenden nichtferromagnetischen Trennschicht. Im einfachsten Fall bestehen dabei beide Systeme aus jeweils einer ferromagnetischen Schicht.

Typischerweise ist die erste ferromagnetische Schicht dabei aus einem hartmagnetischen Werkstoff, etwa einer Kobald-Eisen-Legierung. Diese ferromagnetische Schicht fungiert mit einer nach Betrag und Richtung konstanten Magnetisierung als Referenzschicht.

Die zweite ferromagnetische Schicht aus einem weichmagnetischen Werkstoff, typischerweise einer Nickel-Eisen-Legierung, bildet eine Speicherschicht. Die Ausrichtung der Magnetisierung der Speicherschicht erfolgt korrespondierend zu einem Dateninhalt der Speicherzelle gleich- oder entgegengerichtet der Magnetisierung der Referenzschicht. Die Speicherzelle weist also zwei unterscheidbare Magnetisierungszustände (gleichgerichtet, entgegengerichtet) entsprechend ihrem Dateninhalt auf.

Basiert die magnetoresistive Speicherzelle auf dem Tunneleffekt, so ist der Werkstoff der Trennschicht ein Dielektrikum. Die Häufigkeit eines Übergangs von Elektronen von einer ferromagnetischen Schicht zur anderen ist bei gleichgerichteter Magnetisierung der beiden ferromagnetischen Schichten höher als bei einer entgegengerichteten Magnetisierung der beiden Schichten. Aus der Leitfähigkeit des Schichtsystems kann auf die Orientierung der Magnetisierung der Speicherschicht relativ zur Magnetisierung der Referenzschicht und damit auf den Dateninhalt der Speicherzelle zurückgeschlossen werden.

Je ausgeprägter der Unterschied der Leitfähigkeit bzw. des elektrischen Widerstands für die beiden Magnetisierungszustände der magnetoresistiven Speicherzelle ist, desto störungssicherer und einfacher kann der Dateninhalt der Speicherzelle ausgelesen werden. Der Unterschied im Widerstandsverhalten wird umso größer, je weniger magnetische Domänenbereiche die beiden ferromagnetischen Schichten aufweisen und je höher die Spinpolarisation innerhalb der beiden Schichten ist.

Beim derzeitigen Stand der Technik beträgt die Widerstandsdifferenz für die beiden Magnetisierungszustände bei auf dem Tunneleffekt basierenden magnetoresistiven Speicherzellen beispielsweise 15 - 20%. In einer magnetoresistive Speicherzellen aufweisenden Halbleitereinrichtung kann dagegen der Widerstand zweier in der Halbleitereinrichtung benachbarter Speicherzellen mit gleichem Magnetisierungszustand auch deutlich mehr als 20% betragen. Die Leitfähigkeit divergiert also zwischen zwei Speicherzellen gleicher Magnetisierung in der selben Größenordnung, wie zwischen den beiden Magnetisierungszuständen einer Speicherzelle. Dadurch wird die Auswertung des Magnetisierungszustands und eine Bewertung des Dateninhalts einer Speicherzelle erheblich erschwert.

In herkömmlichen Konzepten für die Referenzschicht einer magnetoresistiven Speicherzelle wird die Referenzschicht als magnetisch harte Schicht ausgelegt, die ihre Magnetisierung im Verlauf eines Fertigungsprozesses für eine magnetoresistive Speicherzelle aufweisende Halbleitereinrichtung erfährt und diese im Wesentlichen für eine Gesamtlebensdauer der Halbleitereinrichtung beibehält. Temperatur- und Langzeitdatenstabilität der magnetoresistiven Speicherzelle hängen direkt von der Stabilität der Magnetisierung der Referenzschicht ab.

In aktuellen Konzepten wird die Referenzschicht entweder an natürliche antiferromagnetische Schichten gekoppelt (gepinnt) oder mit mindestens einer weiteren ferromagnetischen Schicht entgegengerichteter Magnetisierung zu einem artifiziellen Antiferromagneten ergänzt. Solchermaßen über die Rudermann-Kittel-Kasuya-Yoshida-(RKKY-)Wechselwirkung verkoppelte ferro- bzw. antiferromagnetischen Systeme weisen gegenüber einzelnen hartmagnetischen Schichten eine verbesserte Temperatur- und Langzeitdatenstabilität auf und sind unempfindlicher gegen Störmagnetfelder.

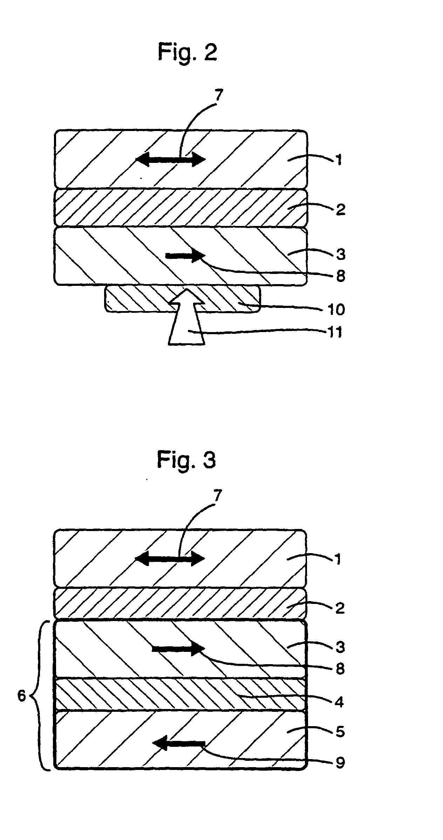

Fig. 3 stellt einen schematischen Querschnitt durch eine magnetoresistive Speicherzelle dar. Beidseits einer Tunnelbarriere 2 liegen einander ein Referenzsystem 6 und ein Speichersystem, das in diesem Fall aus einer einzelnen Speicherschicht 1 besteht, gegenüber. Die Referenzschicht 3 ist eine zur Tunnelbarriere 2 orientierte Teilschicht des Referenzsystems 6. Das Referenzsystem 6 ist in diesem Fall als ein artifizielles antiferromagnetisches Schichtsystem (AAF), bestehend aus der Referenzschicht 3 und einer Referenzkoppelschicht 5 beidseits einer Distanzschicht (eines Spacers) 4, ausgeprägt, wobei eine Magnetisierung 9 der Referenzkoppelschicht 5 einer Referenzmagnetisierung 8 der Referenzschicht 3 entgegengerichtet ist.

In ähnlicher Weise kann die Referenzschicht 3 (dann als pinned layer) über den Spacer 4 an eine andere Schicht (pinning layer) aus einem natürlich antiferromagnetischen Werkstoff gekoppelt sein. Solche Konzepte sind von magnetischen Sensoren und insbesondere von magnetischen Schreib-Leseköpfen bekannt.

Zwischen der Referenzschicht 8 bzw. dem Referenzsystem 6 und der Speicherschicht 7 wirken mehrere Koppelmechanismen, etwa die Néel-Wechselwirkung (orange peel coupling), das pinholecoupling sowie Wechselwirkungen über magnetische Streufelder.

Stark miteinander verkoppelte Schichten reagieren gegenüber einer Ummagnetisierung träger als schwach gekoppelte Systeme. Daher versuchen gegenwärtige Konzepte für Referenzsysteme, die Beträge dieser Wechselwirkungen zu verkleinern, um bessere dynamische Eigenschaften der magnetoresistiven Speicherzelle zu erzielen.

Zum anderen führt ein aus der Summe der Wechselwirkungen resultierendes Biasfeld in der Speicherschicht der magnetoresistiven Speicherzelle zu einem asymmetrischen Schaltverhalten der Speicherschicht. Daher versuchen die aktuellen Konzepte, eine Kompensation der magnetischer Koppelmechanismen am Ort der Speicherschicht zu erzielen.

Zusammenfassend ergeben sich für die Referenzschicht, bzw. ein Referenzschichtsystem folgende, teilweise gegensätzliche Anforderungen:
- Temperaturstabilität, Langzeitdatenstabilität und Magnetfeldunempfindlichkeit erfordern jeweils eine dicke und magnetisch harte Referenzschicht.
- Ein niedriger Betrag der Néel - Kopplung erfordert eine dicke Speicherschicht.
- Ein symmetrisches Schaltverhalten der Speicherschicht setzt eine zuverlässig reproduzierbare Oberflächenrauheit der Referenzschicht sowie ein einstellbares Streufeld voraus.

Es ist daher Aufgabe der Erfindung, eine Anordnung zur Verfügung zu stellen, die eine Widerstandsdifferenz in einer magnetoresistiven Speicherzelle für zwei verschiedenen Magnetisierungszustände erhöht. Außerdem ist ein Verfahren zur Verfügung zu stellen, mit der eine solche Anordnung betrieben werden kann.

Diese Aufgabe wird bei einer Anordnung der eingangs genannten Art erfindungsgemäß durch die im kennzeichnenden Teil des Patentanspruchs 1 angegebenen Merkmale gelöst. Das die Aufgabe lösende Verfahren ist im Patentanspruch 10 angegeben. Vorteilhafte Weiterbildungen der Erfindung ergeben sich jeweils aus den Unteransprüchen.

Bei einer Anordnung der erfindungsgemäßen Art wird also eine Referenzschicht einer in einer Halbleitereinrichtung befindlichen magnetoresistiven Speicherzelle als magnetisch weiche Schicht ausgeführt. Dies erfolgt durch eine Realisierung aus einen weichmagnetischen Werkstoff, etwa einer Nickel-Eisen-Legierung. Ferner kann die Referenzschicht auch dünn ausgeführt werden. Die Referenzschicht enthält dann keine oder wenig Domänen und es liegt eine hohe Spinpolarisation vor.

Beim Beschreiben der Speicherzelle erzeugen Schreibströme in Adressenleitungen der Speicherzelle Magnetfelder, die ausreichend stark sind, um die Magnetisierung einer Speicherschicht der Speicherzelle, wenn notwendig, sicher umzuschalten. Da sich die weichmagnetische Referenzschicht nur wenige Nanometer von der Speicherschicht entfernt befindet, wird auch deren Magnetisierung von den von den Schreibströmen erzeugten Magnetfeldern beeinflusst und ausgelenkt, gegebenenfalls entgegen einer Orientierung der Referenzmagnetisierung ausgerichtet.

Ein folgendes Auslesen der Speicherzelle würde dann stets den parallelen, also niederohmigen Dateninhalt liefern, da ein Lesesystem der Speicherzelle nur die relative Ausrichtung der Magnetisierungen von Speicher- und Referenzschicht (parallel/antiparallel) zu erkennen vermag und nach dem Schreiben beide Schichten stets gleich ausgerichtet sind.

Es muss also sichergestellt werden, dass in der Referenzschicht nach dem Beschreiben der Speicherzelle wieder die ursprüngliche Referenzmagnetisierung hergestellt wird.

Dies erfolgt mit Hilfe eines magnetischen Stützfeldes. Da der Abstand zwischen Referenz- und Speicherschicht in aktuellen Strukturen nur wenige Nanometer beträgt, wirkt dabei ein auf die Referenzschicht wirkendes Stützfeld auch auf die Speicherschicht, deren Orientierung aber unabhängig vom Stützfeld in jedem Fall erhalten bleiben muss.

Dies wird durch eine geeignete Wahl der Koerzitivfeldstärke der Referenzschicht relativ zur Koerzitivfeldstärke der Speicherschicht sichergestellt.

Die Koerzitivfeldstärke der Speicherschicht wird üblicherweise durch die für die Halbleitereinrichtung möglichen Schreibströme vorgegeben.

Das Stützfeld wird so ausgelegt, dass einerseits ein noch in der Speicherschicht wirksamer Anteil deutlich kleiner ist als die Koerzitivfeldstärke der Speicherschicht, um bei antiparalleler Ausrichtung von Stützfeld und der Magnetisierung der Speicherschicht eine ausreichende Störsicherheit zu gewährleisten. Andererseits muss das Stützfeld groß genug sein, um die Referenzschicht zuverlässig auszurichten. Das beinhaltet auch eine ausreichende Stabilität gegen externe dynamische Störfelder.

Für die Koerzitivfeldstärke der Referenzschicht ergibt sich, dass sie einerseits deutlich geringer sein muss als das Stützfeld am Ort der Referenzschicht, um von diesem sicher gesteuert werden zu können. Für den Fall eines temporären und während eines Lesevorgangs absenten Stützfeldes sollte die Koerzitivfeldstärke der Referenzschicht andererseits noch groß genug sein, um einen stabilen Lesevorgang zu ermöglichen, also stark genug, um ausreichend träge auf externe dynamische Störfelder anzusprechen. Die Koerzitivfeldstärke der Referenzschicht kann bei gleicher Stabilität gegen externe Felder geringer gewählt werden, wenn ein stationäres oder ein temporäres und während des Lesevorgangs aktives Stützfeld sich während des Lesevorgangs vektoriell zur Referenzmagnetisierung addiert.

Bevorzugte Werte für die Koerzitivfeldstärken in üblichen Strukturen für magnetoresistive Speicherzellen sind 3kA/m für die Speicherschicht und 0,5 kA/m für die Referenzschicht. Das Stützfeld sollte dann beispielsweise 0,8 kA/m aufweisen.

Das Stützmagnetfeld kann auf verschiedene Weisen erzeugt werden. In einer ersten bevorzugten Ausführungsform wird die Magnetisierung der Referenzschicht durch einen Referenzmagnetisierungsstrom in einer nahe der Referenzschicht geführten Leiterbahn ausgerichtet. Dabei liegt der Referenzmagnetisierungsstrom nur für eine kurze Zeitspanne an. Der Stromimpuls kann entweder an einen Schreibvorgang gebunden sein, in dessen Anschluss er erfolgt oder an einen Lesevorgang, wobei er kurz vor und/oder während des Lesevorgangs ausgelöst wird. Letzteres hat eine höhere Stabilität gegen externe Störfelder zur Folge.

Der Stromimpuls kann immer rein lokal, also bezogen auf die gerade beschriebene oder gleich zu lesende Speicherzelle erfolgen. Die Leiterbahn kann dann eine ohnehin benötigte Leiterbahn sein, die so modifiziert ist, dass sie den Stromimpuls zusätzlich zu ihrer ursprünglichen Funktion leitet. Es können aber auch zu diesem Zweck dedizierte Leiterbahnen vorgesehen werden.

In beiden Fällen kann der Schaltungsaufwand zu Lasten einer höheren Leistungsaufnahme verringert werden, indem der Stromimpuls nicht einzeln adressiert wird, sondern Gruppen von Speicherzellen gleichzeitig adressiert.

In einer zweiten bevorzugten Ausführungsform der Erfindung wird in der Halbleitereinrichtung mindestens ein hartmagnetisches Referenzstützsystem vorgesehen, das durch mindestens eine nichtferromagnetische Schicht von der magnetisch weichen Referenzschicht getrennt ist.

Im einfachsten Fall besteht das Referenzstützsystem aus einer Referenzstützschicht, die eine der Referenzmagnetisierung entgegengesetzte Referenzstützmagnetisierung trägt. Bei dieser Ausführungsform der Erfindung richtet sich die Magnetisierung der Referenzschicht nach jedem Auslenken aus der Richtung der Referenzmagnetisierung wieder selbsttätig nach dieser aus.

Ein Referenzstützsystem kann lokal, also für jede Speicherzelle einzeln, realisiert werden.

In einer bevorzugte Ausführungsform der Erfindung wird das Referenzstützsystem als einfache Referenzstützschicht jedoch über eine gesamte, zu den Referenzschichten parallele Querschnittsfläche der Halbleitereinrichtung aufgebracht. Somit wird in einfacher Weise ein am Ort der Referenzschichten weitgehend homogenes Stützfeld erzeugt.

Eine solche Referenzstützschicht lässt sich innerhalb wie außerhalb der Halbleitereinrichtung vorsehen.

Wird eine Referenzstützschicht innerhalb einer Halbleitereinrichtung aufgebracht, so geschieht dies vorzugsweise auf Wafer-Ebene mittels der zur Bearbeitung eines Wafers üblichen Technologien und mit den bei der Herstellung der Speicherzellen verwendeten Werkstoffen, etwa einer Kobalt-Eisen-Legierung. Die magnetischen Eigenschaften einer solchen Referenzstützschicht können durch ein Strukturieren der Referenzstützschicht gezielt beeinflusst werden.

Innerhalb der Halbleitereinrichtung kann die Referenzstützschicht, etwa durch eine Dielektrikumsschicht von einer anschließenden Passivierungsschicht getrennt, unterhalb der Speicherzellen aufgebracht werden.

Bei Halbleitereinrichtungen mit mehreren Speicherzellenebenen kann jeder Speicherzellenebene jeweils mindestens eine Referenzstützschicht zugeordnet werden, die auf die spezifischen Anforderungen der jeweiligen Speicherzellenebene hin magnetisiert wird. Speicherzellenebenen und Referenzstützschichten wechseln sich in diesem Fall im Schichtaufbau der Halbleitereinrichtung ab. Dabei ist es auch möglich, dass eine Referenzstützschicht mindestens zwei sich jeweils an der Referenzstützschicht gegenüberliegenden Speicherzellenebenen zugeordnet ist.

Wird die Referenzstützschicht während oder nach einem Häusen der Halbleitereinrichtung aufgebracht, so gilt sie in diesem Kontext als Referenzstützschicht außerhalb der Halbleitereinrichtung. Eine solche Referenzstützschicht ist dann allen Speicherzellenebenen gemeinsam zugeordnet.

Eine solche Lösung ist das Verwenden von Gehäusen aus einem ferromagnetischen Werkstoff oder das Platzieren der Halbleitereinrichtung auf einem geeigneten Träger.

Eine bevorzugte Ausführungsform der erfindungsgemäßen Anordnung für eine außerhalb der Halbleitereinrichtung aufgebrachte Referenzstützschicht ist ein vormagnetisiertes Plättchen oder eine vormagnetisierte Folie, die bevorzugt auf mindestens einer zur Referenzschicht parallelen Oberfläche der Halbleitereinrichtung aufgebracht werden.

In jedem Fall kann auch eine für eine Abschirmung der Halbleitereinrichtung gegen äußere Felder vorgesehene Anordnung als Referenzstützschicht oder aber die Referenzstützschicht als Schirmung der Halbleitereinrichtung genutzt werden.

Um ein über alle Speicherzellen homogenes Stützfeld zu erzeugen, wird die Referenzstützschicht bevorzugterweise über eine gesamte, zu den Speicherschichten parallele Querschnittsfläche der Halbleitereinrichtung aufgebracht.

Ein nachträgliches Strukturieren der Referenzstützschicht ermöglicht den Feinabgleich eines Kompensationsfeldes in der Speicherschicht.

Die magnetische Stabilität des Referenzstützsystems prägt die Temperatur- und Langzeitdatenstabilität der magnetoresistiven Speicherzelle. Entsprechend wird das Referenzstützsystem in einer weiteren bevorzugten Ausführungsform der Erfindung als magnetisch hartes Schichtsystem ausgeführt.

Dazu wird die Referenzstützschicht über eine Referenzstützdistanzschicht aus einem leitfähigen, nichtmagnetischen Werkstoff (typischerweise einem Edelmetall wie Ruthenium, Gold, Kupfer, Palladium, Platin, Osmium, Quecksilber oder Rhodium) an eine Referenzstützkoppelschicht aus einem ferromagnetischen Werkstoff (typischerweise eine Kobalt-Eisen-Legierung) mit einer zur Magnetisierung der Referenzstützschicht antiparallelen Magnetisierung (AAF) oder an eine Schicht aus einem natürlich antiferromagnetischen Werkstoff gekoppelt. Durch eine von Rudermann, Kittel, Kasuya und Yoshida beschriebene Wechselwirkung verkleben die Spinpolarisationen in den beiden Schichten beidseits der Referenzstützdistanzschicht. Auf diese Weise wird die Referenzstützschicht magnetisch stabil.

Werden die an der Referenzstützdistanzschicht gegenüberliegende ferromagnetischen Teilschichten eines Referenzstützsystems asymmetrisch, also mit verschiedener Schichtstärke vorgesehen, so weist das Referenzstützsystem ein Nettomoment (im Folgenden Streufeld) auf. Das Streufeld wird zum Stützfeld der Referenzschicht.

Bei geeigneter Dimensionierung lässt sich mit dem Stützfeld auch ein in der Speicherschicht aufgrund verschiedener Koppelmechanismen wirksames Biasfeld kompensieren.

In einer magnetoresistiven Speicherzelle mit magnetisch weicher Referenzschicht ist also die Spinpolarisation in der Referenzschicht gegenüber einem herkömmlichen Aufbau mit hartmagnetischer Referenzschicht deutlich erhöht. Die beiden Zustände der Speicherzelle, also parallele oder antiparallele Ausrichtung der Magnetisierungen von Speicher- und Referenzschicht entsprechend dem binären Dateninhalt der Speicherzelle, sind leichter unterscheidbar. Ein auf der Halbleitereinrichtung vorzusehender Aufwand für eine Schaltung, die den elektrischen Widerstand der Speicherzelle misst und bewertet, wird geringer und die Störsicherheit erhöht.

Die Referenzschicht wird in einer erfindungsgemäßen Anordnung von den die Magnetisierung der Speicherschicht steuernden Magnetfeldern von Schreibströmen beeinflusst. Wird bei einem Schreibvorgang die Speicherschicht gegen die Referenzmagnetisierung magnetisiert, so wirkt das vom Schreibstrom erzeugte Magnetfeld auch gegen die Referenzmagnetisierung. Die Magnetisierung der Referenzschicht wird dabei umgekehrt. Da ein Dateninhalt nach der relativen Orientierung der Magnetisierungen in Speicher- und Referenzschicht bewertet, aber in Form der Orientierung der Magnetisierung der Speicherschicht abgelegt wird, greifen Maßnahmen, die Referenzmagnetisierung wiederherzustellen.

In der Referenzschicht wird also gemäß dem erfindungsgemäßen Verfahren die Referenzmagnetisierung durch ein Referenzstützfeld wiederhergestellt, bevor die magnetoresistive Speicherzelle ausgelesen wird. Damit kann die Beeinflussung der Referenzmagnetisierung durch einen Schreibvorgang hingenommen werden.

Ein Mechanismus (Referenz-Reset) zum Wiederherstellen der Referenzmagnetisierung der Referenzschicht erfolgt unabhängig vom eingelesenen Datum entweder im Anschluss an einen Schreibvorgang oder vor jedem Lesevorgang. Dieser Mechanismus basiert auf bekannten Effekten, wie zum Beispiel Magnetostatik, Neel-Kopplung oder pinhole coupling.

In einer bevorzugten Ausführungsform des erfindungsgemäßen Verfahrens erfolgt der Referenz-Reset vor jedem Lesevorgang. Für den Lesevorgang werden Verfahren gewählt, bei denen die Referenzmagnetisierung ähnlich wie bei einem Schreibvorgang zerstört werden kann. Solche Verfahren bieten eine bessere Unterscheidbarkeit der beiden Zustände der Speicherzelle.

Das Referenzstützfeld wird in einer ersten bevorzugten Ausführungsform der Erfindung als statisches Referenzstützfeld eines hartmagnetischen Referenzstützsystems innerhalb oder außerhalb der Halbleitereinrichtung erzeugt.

In einer zweiten bevorzugten Ausführungsform wird das Referenzstützfeld durch einen Referenzmagnetisierungsstrom erzeugt. Für den Referenzmagnetisierungsstrom wird in einer an die Referenzschicht angrenzenden Passivierungsschicht eine Leiterbahn vorgesehen oder die Beschaltung einer bereits vorhandenen Leiterbahn für diesen Zweck angepasst.

In dieser Ausführungsform der Erfindung wird die Koerzitivfeldstärke der Referenzschicht so ausgelegt, dass die Referenzmagnetisierung stabil gegen das Streufeld der magnetisierten Speicherschicht ist.

Nachfolgend wird die Erfindung anhand der Zeichnungen näher erläutert, wobei für einander entsprechende Komponenten die gleichen Bezugszeichen verwendet werden. Es zeigen:
- **Fig. 1**: schematische Querschnitte durch magnetoresistive Speicherzellen nach einem ersten und einem zweiten Ausführungsbeispiel der Erfindung,
- **Fig. 2**: einen schematischen Querschnitt durch eine magnetoresistive Speicherzelle nach einem dritten Ausführungsbeispiel der Erfindung,
- **Fig. 3**: einen schematischen Querschnitt durch eine herkömmliche magnetoresistive Speicherzelle.

Die Fig. 3 wurde bereits eingangs erläutert.

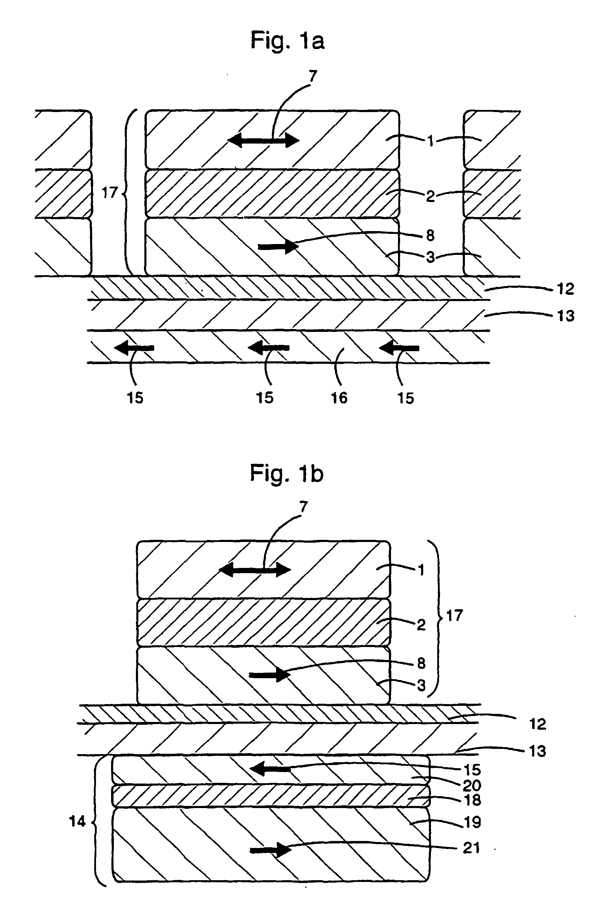

Die beiden Zeichnungen in Fig. 1 zeigen zwei vereinfachte, nicht maßstabsgetreue und auf die Darstellung der für die Erfindung wesentlichen Merkmale beschränkte Querschnitte durch eine Halbleitereinrichtung mit magnetoresistiven Speicherzellen 17.

Eine Speicherzelle 17 besteht aus jeweils einer Speicherschicht 1 und einer Referenzschicht 3 beiderseits einer Tunnelbarriere 2. Die Referenzschicht 3 trägt die Referenzmagnetisierung 8. Die Magnetisierung 7 der Speicherschicht 1 ist entsprechend dem Dateninhalt der Speicherzelle 17 parallel oder antiparallel zur Referenzmagnetisierung 8.

An der Referenzschicht 3 der Tunnelbarriere 2 gegenüberliegend schließt üblicherweise eine Passivierungsschicht (Leiterbahnschicht) 12 an. Die Passivierungsschicht 12 ihrerseits ist auf einer Dielektrikumsschicht 13 aufgebracht.

In Fig. 1a ist das Referenzstützsystem als verteilte Referenzstützschicht 16 ausgeprägt.

Die magnetisch harte Referenzstützschicht 16 trägt eine Referenzstützmagnetisierung 15, die der Referenzmagnetisierung 8 entgegengerichtet ist.

Eine zwischen der Referenzstützschicht 16 und der Referenzschicht 3 wirksame Streufeldkopplung wirkt in Richtung einer antiparallelen Ausrichtung der Magnetisierungen und dreht eine aus der Richtung der Referenzmagnetisierung 8 ausgelenkte Magnetisierung der Referenzschicht 3 wieder in Richtung der Referenzmagnetisierung 8.

In Fig. 1b liegt an der Dielektrikumsschicht 13 der Referenzschicht 3 ein lokales Referenzstützsystem 14 gegenüber. Das lokale Referenzstützsystem 14 erstreckt sich dabei über einen jeweils einer Speicherzelle 17 zugeordneten Bereich.

Dabei wird das Referenzstützsystem 14 aus einer lokalen ferromagnetischen Referenzstützschicht 20 und einer antiferromagnetischen Referenzstützkoppelschicht 19 mit einer Magnetisierung 21 beidseits einer nichtmagnetischen Referenzstützdistanzschicht 18 gebildet. Die Magnetisierungen 20,21 sind über die RKKY-Wechselwirkung fest miteinander verkoppelt. Weichen die Beträge der Magnetisierungen 20,21 voneinander ab, dann bildet das lokale Referenzstützsystem 14 ein Streufeld (Nettomoment) aus, das zum Stützfeld für die Referenzmagnetisierung 8 wird und mit dem eine Kompensation der Neel-Wechselwirkung zwischen der Speicherschicht 1 und der Referenzschicht 3 erzielt werden kann.

Ein von Schreibströmen erzeugtes Schreibmagnetfeld, das die Magnetisierung 7 der Speicherschicht 1 aus einem zur Referenzmagnetisierung 8 parallelen Zustand in einen antiparallelen Zustand schaltet, wirkt in gleicher Weise auch auf die Magnetisierung der Referenzschicht 3.

Zwar ist deren Abstand zur Quelle des Schreibmagnetfeldes größer und damit auch das wirksame Magnetfeld kleiner. Andererseits ist die Koerzitivfeldstärke der magnetisch weichen Referenzschicht 3 deutlich geringer.

Die Magnetisierung der Referenzschicht 3 kann sich aus der zur Referenzstützmagnetisierung 15 antiparallelen Orientierung in eine parallele drehen.

Nach Abklingen des Schreibmagnetfeldes wirken nur noch die Streufeldkopplungen der Speicherschicht 1 und der Referenzstützschicht 16 oder des Referenzstützsystems 14 auf die Referenzschicht 3, wobei die Streufeldkopplung (das Stützfeld) der Referenzstützschicht 16 oder des Referenzstützsystems 14 dominiert.

Da das in der Referenzschicht 3 wirksame Stützfeld stärker als die Koerzitivfeldstärke der magnetisch weichen Referenzschicht 3 ist, dreht sich die Magnetisierung der Referenzschicht 3 wieder in Richtung der Referenzmagnetisierung 8.

In Fig. 2 ist eine zweite Ausführungsform der Erfindung in einem vereinfachten Querschnitt durch eine magnetoresistive Speicherzelle 17 dargestellt.

Die Speicherzelle 17 besteht aus jeweils einer Speicherschicht 1 und einer Referenzschicht 3 beiderseits einer Tunnelbarriere 2. Die Referenzschicht 3 trägt die Referenzmagnetisierung 8. Die Magnetisierung 7 der Speicherschicht 1 ist entsprechend dem Dateninhalt der Speicherzelle 17 parallel oder antiparallel zur Referenzmagnetisierung 8.

In einer Leiterbahn 10, die in diesem Beispiel an einer der Tunnelbarriere 2 gegenüberliegenden Oberfläche der Referenzschicht 3 angeordnet ist, fließt vor und/oder während eines Lesevorgangs an der Speicherzelle 17 in Pfeilrichtung ein Referenzmagnetisierungsstrom 11. Das durch den Referenzmagnetisierungsstrom 11 erzeugte Magnetfeld wirkt in Richtung der Referenzmagnetisierung.

Die Koerzitivfeldstärke der Referenzschicht 3 ist dabei ausreichend groß gegen das Streufeld der Speicherschicht 1.

### Bezugszeichenliste

- 1: Speicherschicht
- 2: Tunnelbarriere
- 3: Referenzschicht
- 4: Distanzschicht (Spacer)
- 5: Referenzkoppelschicht
- 6: Referenzsystem
- 7: Magnetisierung der Speicherschicht
- 8: Referenzmagnetisierung
- 9: Magnetisierung der Referenzkoppelschicht
- 10: Leiterbahn
- 11: Referenzmagnetisierungsstrom
- 12: Passivierungsschicht
- 13: Dielektrikumsschicht
- 14: lokales Referenzstützsystem
- 15: Referenzstützmagnetisierung
- 16: verteilte Referenzstützschicht
- 17: magnetoresistive Speicherzelle
- 18: Referenzstützdistanzschicht
- 19: Referenzstützkoppelschicht
- 20: lokale Referenzstützschicht
- 21: Magnetisierung der Referenzstützkoppelschicht

## Patentansprüche

1. Anordnung zur Erhöhung einer Widerstandsdifferenz einer magnetoresistiven Speicherzelle (17) mit jeweils einer Speicherschicht (1) und einer Referenzschicht (3) beidseits einer Tunnelbarriere (2) zwischen einem ersten Magnetisierungszustand, in dem eine Magnetisierung (7) der Speicherschicht (1) zu einer Referenzmagnetisierung (8) der Referenzschicht (3) gleichgerichtet ist und einem zweiten Zustand, in dem die Magnetisierung (7) zu der Referenzmagnetisierung (8) entgegengerichtet ist, in einer Halbleitereinrichtung,
**dadurch gekennzeichnet, dass**
- die Referenzschicht (3) als magnetisch weiche Schicht ausgeprägt ist und eine hohe Spinpolarisation aufweist,
- bei einem Umschalten der Magnetisierung (7) der Speicherschicht (1) ein Auslenken oder Umschalten der Magnetisierung der Referenzschicht (3) zulässig ist und
- die Orientierung der Magnetisierung der Referenzschicht (3) spätestens vor einem nächsten Lesevorgang an der magnetoresistiven Speicherzelle (17) bei unveränderter Orientierung der Magnetisierung (7) der Speicherschicht (1) wieder in die Richtung der Referenzmagnetisierung (8) einstellbar ist.

2. Anordnung nach Anspruch 1,
**gekennzeichnet durch**
eine Leiterbahn (10), in der vor einem Lesevorgang ein Referenzmagnetisierungsstrom (11) fließt, der die Referenzmagnetisierung (8) in der Referenzschicht (3) zu erzeugen vermag.

3. Anordnung nach Anspruch 1,
**gekennzeichnet durch**
ein magnetisch hartes Referenzstützsystem (14/16) auf der der Tunnelbarriere (2) gegenüberliegenden Seite der Referenzschicht (3), das **durch** mindestens eine nichtmagnetische Schicht (13) von der Referenzschicht (3) getrennt ist und eine Referenzstützmagnetisierung (15) aufweist, die die Referenzmagnetisierung (8) in der Referenzschicht (3) zu erzeugen vermag.

4. Anordnung nach Anspruch 3,
**dadurch gekennzeichnet, dass** jeder magnetoresistiven Speicherzelle (17) innerhalb der Halbleitereinrichtung ein lokales Referenzstützsystem (14) zugeordnet ist.

5. Anordnung nach Anspruch 3,
**dadurch gekennzeichnet, dass** das Referenzstützsystem als verteilte Referenzstützschicht (16) ausgeprägt ist, die parallel zur Referenzschicht (3) verläuft und sich dabei im Wesentlichen über eine gesamte Querschnittsfläche der Halbleitereinrichtung erstreckt.

6. Anordnung nach Anspruch 5,
**dadurch gekennzeichnet, dass** sich die verteilte Referenzstützschicht (16) außerhalb der Halbleitereinrichtung befindet.

7. Anordnung nach einem der Ansprüche 5 oder 6,
**dadurch gekennzeichnet, dass** die Referenzstützschicht (16) für einen Feinabgleich von Streufeldern in der Speicherschicht (1) strukturiert ist.

8. Anordnung nach einem der Ansprüche 5 bis 7
**gekennzeichnet durch**
eine **durch** eine Referenzstützdistanzschicht (18) von der Referenzstützschicht getrennte Referenzstützkoppelschicht (19), die die Magnetisierung (15) einer lokalen Referenzstützschicht (20) fixiert.

9. Anordnung nach Anspruch 8,
**dadurch gekennzeichnet, dass**
die Referenzstützkoppelschicht (19) eine Magnetisierung (21) und die Referenzstützschicht (20) eine betragsmäßig ungleiche Magnetisierung (15) tragen und mit einem daraus resultierenden Streufeld des lokalen Referenzstützsytems (14) eine remanente Néel-Wechselwirkung zwischen der Speicherschicht (1) und der Referenzschicht (3) kompensiert und damit ein Schaltverhalten der Speicherschicht (1) symmetriert wird.

10. Verfahren zum Betrieb einer magnetoresistiven Speicherzelle (17) mit jeweils einer Speicherschicht (1) und einer magnetisch weichen Referenzschicht (3) beidseits einer Tunnelbarriere (2) in einer Halbleitereinrichtung, umfassend die Schritte:
- Ausrichten der Magnetisierung (7) der Speicherschicht (1) der magnetoresistiven Speicherzelle (17) gemäß eines zu speichernden Datums, wobei eine Referenzmagnetisierung (8) der Referenzschicht (3) ausgelenkt werden kann,
- Wiederherstellen der Referenzmagnetisierung (8) der Referenzschicht (3) und
- Auslesen des Datums der magnetoresistiven Speicherzelle (17).

11. Verfahren nach Anspruch 10,
**dadurch gekennzeichnet, dass**
beim Auslesen der magnetoresistiven Speicherzelle (17) die Referenzmagnetisierung (8) der Referenzschicht (3) ausgelenkt werden kann.

12. Verfahren nach einem der Ansprüche 10 bis 11,
**dadurch gekennzeichnet, dass**
zum Wiederherstellen der Referenzmagnetisierung (8) der Referenzschicht (3) ein Referenzmagnetisierungsstrom (11) in einer Leiterbahn (10) nahe der Referenzschicht (3) gesteuert wird.

## Claims

1. Arrangement for increasing a difference in resistance of a magnetoresistive memory cell (17) having in each case a memory layer (1) and a reference layer (3) on both sides of a tunnel barrier (2) between a first magnetization state, in which a magnetization (7) of the memory layer (1) is unidirectional with respect to a reference magnetization (8) of the reference layer (3), and a second state, in which the magnetization (7) is oppositely directed with respect to the reference magnetization (8), in a semiconductor device,
**characterized in that**
- the reference layer (3) is fashioned as a magnetically soft layer and has a high spin polarization,
- in the event of a changeover of the magnetization (7) of the memory layer (1), a deflection or changeover of the magnetization of the reference layer (3) is permissible, and
- the orientation of the magnetization of the reference layer (3) can be set in the direction of the reference magnetization (8) again at the latest before a next read operation on the magnetoresistive memory cell (17) given unaltered orientation of the magnetization (7) of the memory layer (1).

2. Arrangement according to Claim 1,
**characterized by**
an interconnect (10), in which, before a read operation, a reference magnetization current (11) flows, which can generate the reference magnetization (8) in the reference layer (3).

3. Arrangement according to Claim 1,
**characterized by**
a magnetically hard reference backup system (14/16) on that side of the reference layer (3) which is opposite to the tunnel barrier (2), which system is isolated from the reference layer (3) by at least one nonmagnetic layer (13) and has a reference backup magnetization (15), which can generate the reference magnetization (8) in the reference layer (3).

4. Arrangement according to Claim 3,
**characterized in that**
a local reference backup system (14) is assigned to each magnetoresistive memory cell (17) within the semiconductor device.

5. Arrangement according to Claim 3,
**characterized in that**
the reference backup system is fashioned as a distributed reference backup layer (16), which runs parallel to the reference layer (3) and at the same time essentially extends over an entire cross-sectional area of the semiconductor device.

6. Arrangement according to Claim 5,
**characterized in that**
the distributed reference backup layer (16) is situated outside the semiconductor device.

7. Arrangement according to either of Claims 5 and 6,
**characterized in that**
the reference backup layer (16) is structured for a fine adjustment of leakage fields in the memory layer (1).

8. Arrangement according to one of Claims 5 to 7,
**characterized by**
a reference backup coupling layer (19), which is isolated from the reference backup layer by a reference backup spacer layer (18) and fixes the magnetization (15) of a local reference backup layer (20).

9. Arrangement according to Claim 8,
**characterized in that**
the reference backup coupling layer (19) carries a magnetization (21) and the reference backup layer (20) carries a magnetization (15) with a magnitude that is not the same, and a resultant leakage field of the local reference backup system. (14) is used to compensate for a remanent Néel interaction between the memory layer (1) and the reference layer (3) and thus to symmetrize a switching behaviour of the memory layer (1).

10. Memory for operating a magnetoresistive memory cell (17) having in each case a memory layer (1) and a magnetically soft reference layer (3) on both sides of a tunnel barrier (2) in a semiconductor device, comprising the following steps:
- orientation of the magnetization (7) of the memory layer (1) of the magnetoresistive memory cell (17) in accordance with a datum to be stored, it being possible for a reference magnetization (8) of the reference layer (3) to be deflected,
- reestablishment of the reference magnetization (8) of the reference layer (3), and
- read-out of the datum of the magnetoresistive memory cell (17).

11. Method according to Claim 10,
**characterized in that**
the reference magnetization (8) of the reference layer (3) can be deflected during the read-out of the magnetoresistive memory cell (17).

12. Method according to one of Claims 10 to 11,
**characterized in that**
in order to reestablish the reference magnetization (8) of the reference layer (3), a reference magnetization current (11) is controlled in an interconnect (10) near the reference layer (3).

## Revendications

1. Dispositif pour augmenter une différence de résistance d'une cellule (17) de mémoire magnétorésistive ayant, respectivement, une couche (1) de mémoire et une couche (3) de référence de part et d'autre d'une barrière (2) tunnel entre un premier état d'aimantation, dans lequel une aimantation (7) de la couche (1) de mémoire a le même sens qu'une aimantation (8) de référence de la couche (3) de référence, et un deuxième état, dans lequel l'aimantation (7) est de sens opposé à l'aimantation (8) de référence, dans un dispositif à semi-conducteurs,
**caractérisé en ce que**
- la couche (3) de référence est marquée comme étant une couche à magnétisme doux et a une grande polarisation de spin ;
- lors de la commutation de l'aimantation (7) de la couche (1 ) de mémoire, une déviation ou une commutation de l'aimantation de la couche (3) de référence est autorisée ; et
- l'orientation de l'aimantation de la couche (3) de référence peut être réglée au plus tard après une opération suivante de lecture sur la cellule (17) de mémoire magnétorésistive, alors que l'orientation de l'aimantation (7) de la couche (1) de mémoire est inchangée, en la remettant à nouveau dans le sens de l'aimantation (8) de référence.

2. Dispositif suivant la revendication 1, **caractérisé par** une piste (10) conductrice dans laquelle passe, avant une opération de lecture, un courant (11) d'aimantation de référence qui permet de produire l'aimantation (8) de référence dans la couche (3) de référence.

3. Dispositif suivant la revendication 1, **caractérisé par** un système (14/16) d'appui de référence à magnétisme dur du côté, opposé à la barrière de tunnel, de la couche (3) de référence qui est séparé de la couche (3) de référence par au moins une couche (13) amagnétique et qui a une aimantation (15) d'appui de référence qui permet de produire l'aimantation (8) de référence dans la couche (3) de référence.

4. Dispositif suivant la revendication 3, **caractérisé en ce qu'**à chaque cellule (17) de mémoire magnétorésistive est associé à l'intérieur du dispositif à semi-conducteur un système (14) local d'appui de référence.

5. Dispositif suivant la revendication 3, **caractérisé en ce que** le système d'appui de référence est marqué comme étant une couche (16) d'appui de référence répartie, qui s'étend parallèlement à la couche (3) de référence et qui s'étend essentiellement sur toute une surface de section transversale du dispositif à semi-conducteurs.

6. Dispositif suivant la revendication 5, **caractérisé en ce que** la couche (16) d'appui de référence répartie se trouve à l'extérieur du dispositif à semi-conducteurs.

7. Dispositif suivant l'une des revendications 5 ou 6, **caractérisé en ce que** la couche (16) d'appui de référence est structurée pour une égalisation fine des champs de dispersion dans la couche (1) de mémoire.

8. Dispositif suivant l'une des revendications 5 à 7, **caractérisé par** une couche (19) de couplage d'appui de référence séparée de la couche d'appui de référence par une couche (18) de mise à distance d'appui de référence qui fixe l'aimantation (15) d'une couche (20) d'appui de référence locale.

9. Dispositif suivant la revendication 8, **caractérisé en ce que** la couche (19) de couplage d'appui de référence porte une aimantation (21) et la couche (20) d'appui de référence une aimantation (15) différente en valeur absolue et par un champ de dispersion qui s'ensuit du système (14) d'appui de référence local, une interaction de Néel rémanente entre la couche (1) de mémoire et la couche (3) de référence est compensée et, ainsi, un comportement de commutation de la couche (1) de mémoire est rendu symétrique.

10. Procédé pour faire fonctionner une cellule (17) de mémoire magnétorésistive ayant, respectivement, une couche (1) de mémoire et une couche (3) de référence à magnétisme doux de part et d'autre d'une barrière (2) tunnel dans un dispositif à semi-conducteurs comprenant les stades dans lesquels :
- on dirige l'aimantation (7) de la couche (1) de mémoire de la cellule (17) de mémoire magnétorésistive suivant une donnée à mémoriser, une aimantation (8) de référence de la couche (3) de référence pouvant être déviée ;
- on rétablit l'aimantation (8) de référence de la couche (3) de référence ; et
- on lit la donnée de la cellule (17) de mémoire magnétorésistive.

11. Procédé suivant la revendication 10, **caractérisé en ce que**, à la lecture de la cellule (17) de mémoire magnétorésistive, on peut dévier l'aimantation (8) de référence de la couche (13) de référence.

12. Procédé suivant l'une des revendications 10 à 11, **caractérisé en ce que**, pour rétablir l'aimantation (8) de référence de la couche (3) de référence, on commande un courant (11 ) d'aimantation de référence dans une piste (10) conductrice à proximité de la couche (3) de référence.
